# EUROPEAN PATENT SPECIFICATION

(11) **EP 3 935 739 B1**
(45) Date of publication and mention of the grant of the patent: **24.04.2024**
(21) Application number: 19714200.3
(22) Date of filing: 27.03.2019
(51) Int. Cl.: H04B 1/04, H04B 1/18, H04B 1/525, H03F 3/60, H04B 1/44, H04B 1/50, H04B 1/56, H04L 5/14, H03F 3/24

(54) **RADIO FREQENCY FRONT END FOR A FULL DUPLEX OR HALF DUPLEX TRANSCEIVER**
HOCHFREQUENZ-FRONTEND FÜR EINEN VOLLDUPLEX- ODER HALBDUPLEX-SENDEEMPFÄNGER
EXTRÉMITÉ FRONTALE RADIOFRÉQUENCE POUR UN ÉMETTEUR-RÉCEPTEUR EN DUPLEX INTÉGRAL OU SEMI-DUPLEX

(43) Date of publication of application: 12.01.2022
(73) Proprietor: Huawei Technologies Co., Ltd., Shenzhen, Guangdong 518129 (CN)
(72) Inventor: SHILO, Shimon, 80992 Munich (DE); TSODIK, Genadiy, 80992 Munich (DE); EZRI, Doron, 80992 Munich (DE); REGEV, Dror, 80992 Munich (DE)
(74) Representative: Roth, Sebastian
(86) International application number: PCT/EP2019/057796
(87) International publication number: WO 2020/192917

(56) References cited:
- US-A1- 2009 190 509
- US-A1- 2010 304 701
- US-A1- 2015 085 710
- REGEV DROR ET AL: "Modified re-configurable quadrature balanced power amplifiers for half and full duplex RF front ends", 2018 TEXAS SYMPOSIUM ON WIRELESS AND MICROWAVE CIRCUITS AND SYSTEMS (WMCS), IEEE, 5 April 2018 (2018-04-05), pages 1-4, XP033368672, DOI: 10.1109/WMCAS.2018.8400625 [retrieved on 2018-06-29]

## Description

### TECHNICAL FIELD

The present invention relates to a Radio Frequency (RF) front end for wireless communications, in particular for use in a Half Duplex (HD), Full Duplex (FD) and/or Frequency Division Duplex (FDD) transceiver. Accordingly, the invention also relates to a transceiver with a multi-mode RF front end. The RF front end of the invention is especially based on a Quadrature Balanced Power Amplifier (QBPA).

### BACKGROUND

In transmit and receive (T/R) antenna wireless communication scenarios, a Low Noise Amplifier (LNA) in the receive path needs to be protected from a transmit signal leakage (TX leakage). In most scenarios, a minimum T/R isolation required to protect the LNA is about 30 dB. For simultaneous transmit receive (STR) antenna wireless communication scenarios, such as FD or FDD without a Diplexer, a minimum T/R isolation of 50-60 dB is required. Hence, a Transmit-Receive Self Interference Cancellation (SIC) mechanism is needed for STR wireless systems.

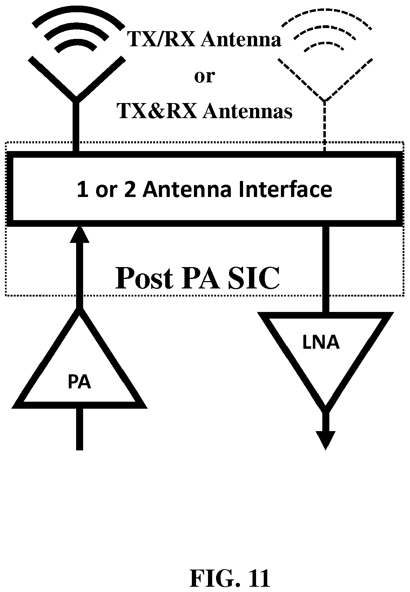

Conventional implementations of such SIC are implemented at an output of a power amplifier (PA), i.e. between the transmit (TX) output and the receive (RX) input, hence they "load" both TX and RX channels, thus creating a loss of power efficiency and of signal to noise ratio. FIG. 11 shows conceptually an example of a conventional SIC implementation, as it is common in wireless communication applications. A SIC unit is implemented at the PA output (i.e. "post-PA"). In particular, an input signal of the SIC unit is an output signal from the PA. Such implementation introduces both power efficiency loss and signal to noise ratio degradation.

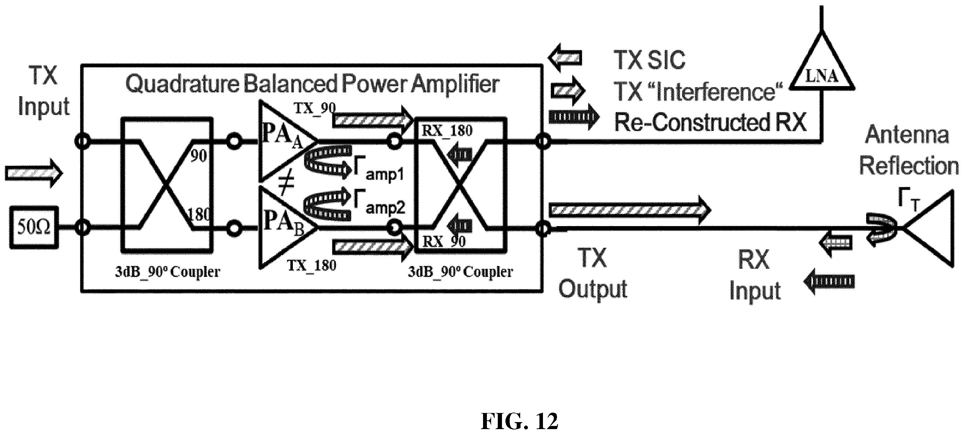

FIG. 12 shows a first example of a modified Quadrature Balanced Power Amplifier (QBPA) RF Front End (RFFE). This example bases in particular on a modified QBPA with un-equal transmit paths (unequal PA_{A} and PA_{B}). Such a 3 ports version RFFE includes a TX input port an RX output port and an antenna TR/RX port. The modification enables the flexibility to create a feed-forward TX cancellation signal in the receive path with the right amplitude and anti-phase to the TX signal reflected from the antenna. Hence, the first example realizes a dual mode RF front end with a built-in SIC capability, so as to increase the isolation between transmit and receive ports.

However, the first example requires control of both amplitude and phase of the two PA paths of PA_{A} and PA_{B}, which adds considerable complexity to the front end design. Further, the first example is limited in isolation of a wide-band signal, but the use of such a wide-band signal is of high interest.

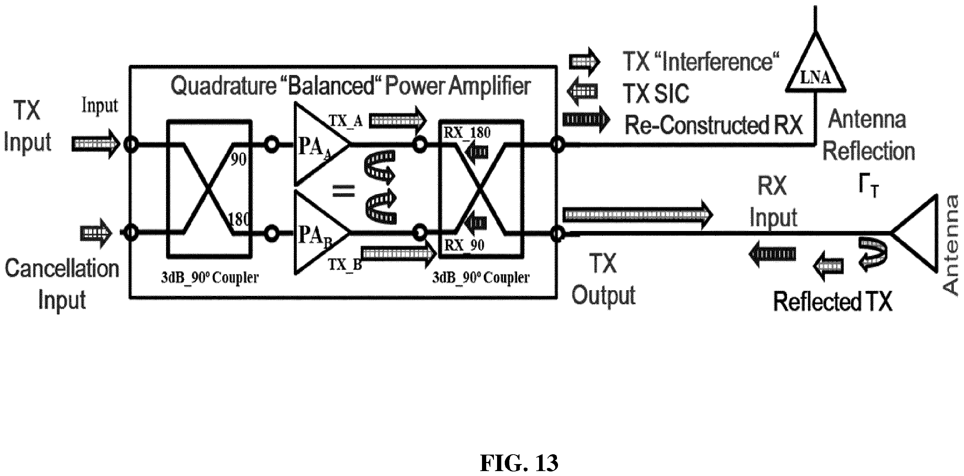

FIG. 13 thus shows a second example of a modified QBPA RFFEs. This 4 ports version adds a SIC input port. It takes advantage of the QBPA structure, and employs two identical transmit paths (PA_{A} = PA_{B}). In this way, the feed forward cancellation signal is injected from the 4th port that was previously un-used, after normalizing by the gain of the two equal paths. The cancellation signal will re-construct at the receive port to cancel the transmit signal reflected from the antenna.

US 2010/304701 A1 discloses an apparatus and method for removing a transmission leakage signal. The apparatus includes: a directional coupler connecting an antenna to a transmission path and a reception path; and a reflection coefficient adjustment unit outputting a reflection signal to the reception path, the reflection signal having the same amplitude as and opposite phase to a first transmission leakage signal generated from the transmission path and input to the reception path and a second transmission leakage signal reflected by the antenna and input to the reception path. Regev Dror et al, "Modified re-configurable quadrature balanced power amplifiers for half and full duplex RF front ends", 2018 Texas Symposium on Wireless and Microwave Circuits and Systems, IEEE, (20180405), pages 1 - 4, discusses an RFFE architecture for dual-mode half and full duplex operation, employing a modified QBPA, where the receive channel is connected to the QBPA transmit isolated output. US 2009/190509 A1 discloses an apparatus in a Time Division Duplex (TDD) wireless communication system, which includes two 90° hybrid couplers and a phase converter block. US 2015/085710 A1 discloses a wireless transceiver including a transmit path configured to generate an RF transmit signal for transmission via an antenna.

### SUMMARY

In view of the above-mentioned disadvantages and examples, embodiments of the present invention aim to provide an improved multi-mode RF front end. An objective is in particular to design a multi-mode RF front end with an improved power efficiency of a SIC implementation. The multi-mode RF front end should be easy to integrate, e.g. on a chip and/or PCB, and should have a low SIC signal to noise degradation.

The objective is achieved by the embodiments provided in the enclosed independent claims. Advantageous implementations of the embodiments are further defined in the dependent claims.

In particular the embodiments can generate SIC signal/s for either version and mostly for 4 port modified QBPA. All the new embodiments generate the SIC signal in a "pre-PA" manner and reuse the QBPA power amplifiers to amplify the SIC signals as well, together with the TX signal. This dramatically improves an efficiency of the SIC implementation and minimizes signal to noise losses.

A first aspect of the invention provides a RF front end for wireless communication, comprising an antenna port for outputting a transmit signal to and receiving a receive signal from an antenna, a receive port for outputting the receive signal to a signal processing section, a cancellation input signal generator for generating a cancellation input signal and outputting the cancellation input signal to a QBPA, and the QBPA comprising a first, second, third and fourth port, wherein the QBPA is configured to: receive a transmit input signal at the first port or the fourth port, receive the receive signal at a second port connected to the antenna port, receive the cancellation input signal from the cancellation input signal generator, amplify the transmit input signal and the cancellation input signal, generate the transmit signal from the transmit input signal and output the transmit signal at the second port, generate a cancellation signal from the cancellation input signal and output the cancellation signal and the receive signal at the third port connected to the receive port.

The cancellation input signal is generated by the cancellation input signal generator in a "pre-PA" manner. In particular, the cancellation input signal is output to the QBPA, thus, the QBPA amplifies the SIC signal(s) together with the TX signal(s). The cancellation signal is reconstructed at the third port, and can thus cancel leakage signals caused at the third port when operating in transmit mode (TX leakage). In particular, the cancellation signal can cancel the transmit signal that is reflected from the antenna (TX antenna reflections). The four-port RF front end of the first aspect enables multi-mode operation with re-using amplifiers, and particularly has a reduced SIC power consumption.

In an implementation form of the first aspect, the cancellation input signal generator is configured to generate the cancellation input signal based on the transmit input signal and/or based on an SIC signal received at the first or fourth port.

In this way, there is no need to feed an extra signal for constructing the cancellation input signal. Alternatively, an extra SIC signal may also be injected to the cancellation input signal generator to form the cancellation input signal.

In an implementation form of the first aspect, the cancellation input signal generator is configured to generate the cancellation input signal in a manner that the cancellation signal cancels a leakage signal caused at the third port when the transmit signal is output from the second port.

Accordingly, the T/R isolation properties of the RF front end of the first aspect are improved. Further, by adjusting the cancellation input signal, the T/R isolation can be adapted to different leakage mechanisms. Thus, the RF front end of the first aspect offers a large flexibility.

In a further implementation form of the first aspect, the QBPA comprises a first coupler configured to divide an input signal received from the first or the fourth port of the QBPA into a first part and second part, with a phase difference of 90° between the first part and second part, wherein the input signal is the transmit input signal or the cancellation input signal; a first amplifier configured to amplify the first part of the input signal and output the amplified first part of the input signal to a second coupler; a second amplifier configured to amplify the second part of the input signal and output the amplified second part of the input signal to the second coupler; and the second coupler configured to combine the amplified first and second parts of the input signal to form a first and second output signal at the second and third ports of the QBPA, respectively.

The QBPA comprises two power amplifiers. Optionally, the first amplifier and the second amplifier may provide different gains. Alternatively, the amplification by the first amplifier may be the same as the amplification by the second amplifier.

In a further implementation form of the first aspect, the input signal of the first coupler comprises the transmit input signal, wherein the second coupler is configured to combine the amplified first and second parts of the transmit input signal such that they constructively form the transmit signal at the second port and destructively cancel each other at the third port.

Thus, a transmit signal leakage to the third port (i.e. towards the signal processing section used to process the receive signal) is reduced or even non-existent (notably not (yet) taking into account antenna reflections of the transmit signal).

In a further implementation form of the first aspect, the cancellation input signal generator comprises a first SIC filter arranged between the first coupler and the first amplifier, and a second SIC filter arranged between the first coupler and the second amplifier, wherein the first SIC filter is configured to: receive the first part of the input signal from the first coupler, generate a first cancellation input signal, and output the first cancellation input signal to the first amplifier; and the second SIC filter is configured to: receive the second part of the input signal from the first coupler, generate a second cancellation input signal, and output the second cancellation input signal to the second amplifier.

A maximum SIC degree of freedom may be achieved by implementing two independent analog SIC filters at each PA input. This, however, may not provide the smallest form factor or efficiency, especially with passive delay lines SIC or generate noise and non-linearity with active SIC filters.

In a further implementation form of the first aspect, the second coupler is further configured to combine the amplified first and second cancellation input signal such that they constructively form the cancellation signal at the third port and destructively cancel each other at the second port.

The cancellation signal at the third port can cancel any T/R leakage, for instance, reflections of the transmit signal at the antenna, which reconstructs at the third port.

In a further implementation form of the first aspect, the RF front end further comprises a splitter, and the cancellation input signal generator comprises a third SIC filter, wherein the splitter is configured to: receive the transmit input signal, split the transmit input signal into a third and fourth parts, output the third part of the transmit input signal to the third SIC filter and output the fourth part of the transmit input signal to the fourth port of the QBPA connected to the first coupler; and the third SIC filter is configured to: receive the third part of the transmit input signal from the splitter, generate the cancellation input signal, and output the cancellation input signal to the first coupler.

Optionally, the TX input signal may be split into two different QBPA inputs. The TX signal may be higher in power and the SIC signal may be fed to the other input after passing an analog SIC filter. This alternative design may better suit passive SIC filtering.

In a further implementation form of the first aspect, the RF front end further comprises an in-phase and quadrature digital-to-analog converter, IQ DAC, an IQ baseband processing component, IQ BB, and a first and second mixers, and the cancellation input signal generator comprises a BB SIC filter, wherein the IQ DAC is configured to receive a digital signal, convert the digital signal to an analog signal and output the analog signal to the IQ BB; the IQ BB is configured to receive the analog signal from the IQ DAC, generate a BB signal from the analog signal and output the BB signal to the BB SIC filter and the first mixer; the BB SIC filter is configured to receive the BB signal from the IQ BB, generate a BB cancellation input signal from the BB signal and output the BB cancellation input signal to the second mixer; the first mixer is configured to receive the BB signal from the IQ BB, mix the BB signal with a low-frequency signal to form the transmit input signal, and output the transmit input signal to the fourth port of the QBPA; the second mixer is configured to receive the BB cancellation input signal from the BB SIC filter, mix the BB cancellation signal with the low-frequency signal to form the cancellation input signal, and output the cancellation input signal to the first port of the QBPA.

The implementation of RF SIC filters may be too large physically and/or too complicated for some applications. Thus, a simple analog baseband (BB) SIC implementation may be up-converted to RF as described in this implementation form. A complex low frequency signal is used to generate the transmit input signal and the cancellation input signal.

In a further implementation form of the first aspect, the QBPA is configured to: receive the cancellation input signal from the cancellation input signal generator at the first port, and receive the transmit input signal at the fourth port.

A TX chain and a SIC chain may be separate. In particular, the cancellation input signal may be fed to one port of the QBPA, and the transmit input signal may be fed to another port of the QBPA.

In a further implementation form of the first aspect, the second coupler is further configured to combine the amplified first and second parts of the cancellation input signal such that they constructively form the cancellation signal at the third port and destructively cancel each other at the second port.

A second aspect of the invention provides a FD or HD transceiver comprising a RF front end according to the first aspect or any of its implementation forms, and a transmit and receive antenna connected to the antenna port of the RF front end.

Accordingly, the transceiver of the second aspect achieves the advantages and effects of the RF front end of the first aspect.

In an implementation form of the second aspect, if the TX chain and the SIC chain are separate, the transceiver further comprises a digital baseband processing module, a digital front end and an analog baseband and RF processing module, wherein the digital baseband processing module is configured to: receive a frequency signal, generate a first and second sequences from the frequency signal, and output the first and second sequences to the digital front end; the digital front end is configured to: receive the first and second sequences from the digital baseband processing module, convert the received first and second sequences, and output converted first and second sequences to the analog baseband and RF processing module; and the analog baseband and RF processing module is configured to: receive the converted first and second sequences from the digital front end,
generate a cancellation input signal from the converted first sequence and output the cancellation input signal to a first port of a QBPA in the RF front end, and generate a transmit input signal from the converted second sequence and output the transmit input signal to a fourth port of the QBPA in the RF front end.

The implementation of analog SIC filters may be physically too large and/or too complicated for some applications. Thus, a simple digital BB SIC implementation may be up-converted to RF as described in this implementation form. After a digital signal processing procedure, digital signals may be converted to RF signals including the transmit input signal and the cancellation input signal.

In an implementation form of the second aspect, the digital baseband processing module is further configured to convert a mix of the frequency signal and a SIC coefficient to form the first sequence.

In another implementation form of the second aspect, the first sequence is identical to the second sequence, and the digital front end is further configured to filter the received first sequence before converting it.

It has to be noted that all devices, elements, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof.

### BRIEF DESCRIPTION OF DRAWINGS

The above described aspects and implementation forms of the present invention will be explained in the following description of specific embodiments in relation to the enclosed drawings, in which
- FIG. 1: shows a multi-mode RF front end according to an embodiment of the invention.
- FIG. 2: shows a multi-mode RF front end according to an embodiment of the invention.
- FIG. 3: shows a multi-mode RF front end according to an embodiment of the invention.
- FIG. 4: shows a multi-mode RF front end according to an embodiment of the invention.
- FIG. 5: shows a multi-mode RF front end according to an embodiment of the invention.
- FIG. 6: shows a multi-mode RF front end according to an embodiment of the invention.
- FIG. 7: shows a transceiver (FD, FDD or HD) according to an embodiment of the invention.
- FIG. 8: shows a transceiver (FD, FDD or HD) according to an embodiment of the invention.
- FIG. 9: shows a transceiver (FD, FDD or HD) according to an embodiment of the invention.
- FIG. 10: shows a method according to an embodiment not falling within the scope of the claimed subject-matter.
- FIG. 11: shows conceptually an example of a conventional SIC implementation.
- FIG. 12: shows an example of a modified QBPA RF front end.
- FIG. 13: shows another example of a modified QBPA RF front end.

### DETAILED DESCRIPTION OF EMBODIMENTS

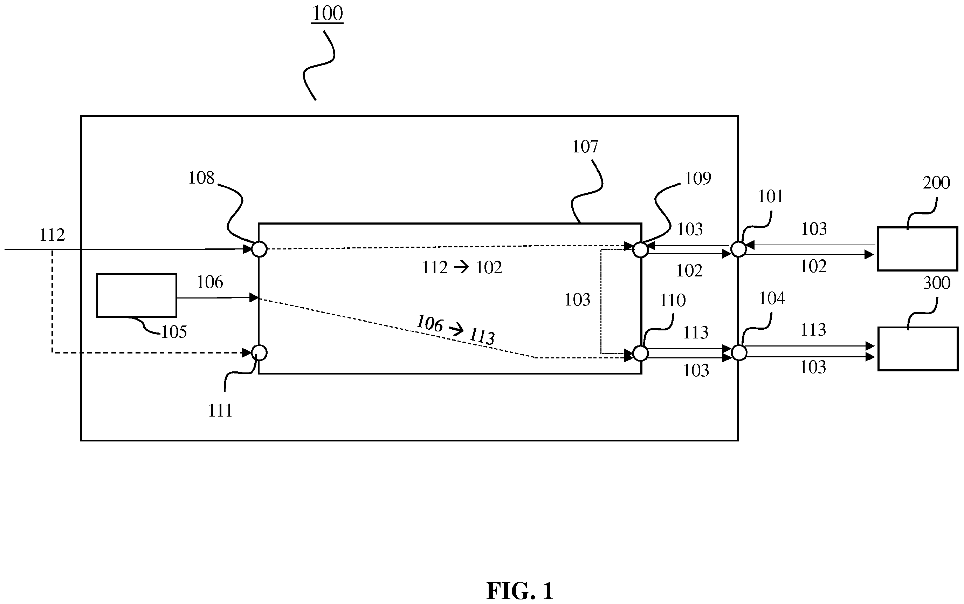

FIG. 1 shows a RF front end 100 according to an embodiment of the invention. The RF front end 100 is in particular a multi-mode RF front end, which is suitable for HD, FD and FDD wireless communications, for instance, in an HD, FD or FDD transceiver.

The RF front end 100 has an antenna port 101, to which an antenna 200 can be connected. The antenna port 101 is used to output a transmit signal 102 to the antenna 200 (in a transmit mode), and is used to receive a receive signal 103 from the antenna 200 (in a receive mode), either simultaneously (FD) or not simultaneously (HD).

The RF front end 100 also has a receive port 104, to which a receive path including a signal processing section 300 can be connected. The receive port 104 is used to output the receive signal 103, as received from the antenna 200 via the antenna port 101, to the signal processing section 300.

The RF front end 100 also has a cancellation input signal generator 105. The cancellation input signal generator 105 generates a cancellation input signal 106 and outputs the cancellation input signal 106 to a QBPA 107 of the RF front end 100.

Thus, the RF front end 100 further has the QBPA 107. The QBPA 107 acts as a T/R isolation stage and allows STR. The QBPA 107 includes four ports, namely a first port 108, a second port 109, a third port 110, and a fourth port 111. The second port 109 is connected to the antenna port 101, i.e. it is used to provide the transmit signal 102 to the antenna 200 and to receive the receive signal 103 from the antenna 200. The third port 110 is connected to the receive port 104, i.e. it is used to provide the receive signal 103 to the signal processing section 300.

The QBPA 107 is in particular configured to receive a transmit input signal 112 at the first port 108 or the fourth port 111, and to receive the cancellation input signal 106 from the cancellation input signal generator 105. The cancellation input signal 106 may be received at the first port 108 or the fourth port 111, or it can be received at other port inside the QBPA 107. For instance, the cancellation input signal 106 may be injected to an internal unit of the QBPA 107. Further, the QBPA 107 is configured to receive the receive signal 103 at the second port 110.

The QBPA 107 is configured to amplify the transmit input signal 112 and the cancellation input signal 106. It should be noted that the cancellation input signal 106 is generated before the PA input, and it is thus amplified together with the transmit input signal 112.

The QBPA 107 is further configured to generate the transmit signal 102 from the transmit input signal 112 and output it at the second port 109, to generate a cancellation signal 113 from the cancellation input signal 106 and output it at the third port 110, and to output the receive signal 103 received at the second port 110 at the third port 110.

Accordingly, in a transmit mode, the transmit signal 102 is generated (indicated by the dashed line 112→102) and provided to the antenna 200. Further, the cancellation signal 113 is generated (indicated by the dashed line 106→113) and provided to the signal processing section. Optionally, a SIC filter may be used to generate the cancellation input signal 106. Optionally, the cancellation input signal generator 105 may be configured to generate the cancellation input signal 106 based on the transmit input signal 112 and/or based on an SIC signal received at the first port 108 or fourth port 111. In particular, the cancellation signal 113 may cancel any leakage caused by the transmit signal 102 output to the antenna 200, e.g. reflections of the transmit signal 102 at the antenna 200, which are reflected back to the antenna port 101/second port 109 or cancel any other imperfections leading to other TX signal "leakage" phenomena between the second port 109 and the third port 110. In a receive mode, the receive signal 103 is conveyed from the second port 109 to the third port 110 (indicated by the dotted line) and provided to the signal processing section 300. As mentioned above, the transmit mode and receive mode may be set simultaneously.

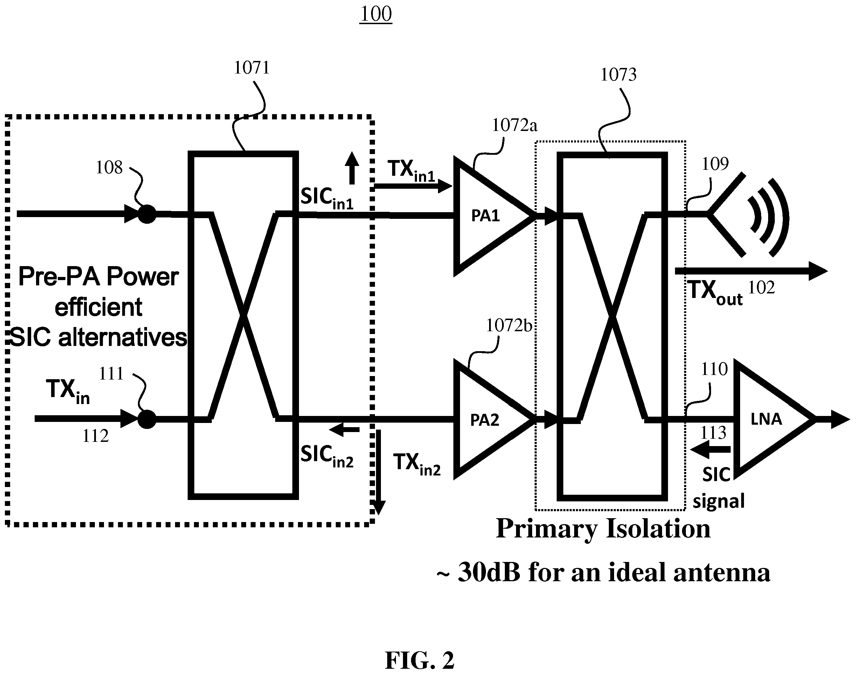

FIG. 2 shows a multi-mode RF front end 100 according to an embodiment of the invention, which builds on the RF front end 100 shown in FIG. 1. Accordingly, same elements are provided with the same reference signs. FIG. 2 shows in particular how the transmit signal 102 is generated from the transmit input signal 112, and how the cancellation signal 111 is generated from "pre-PA" cancellation input signals. To this end, the QPBA 107 includes a first coupler 1071, a first amplifier 1072a, a second amplifier 1072b, and a second coupler 1073. The first coupler 1071, first amplifier 1072a and second coupler 1073 form at least part of a first signal path, and the first coupler 1071, second amplifier 1072b, and second coupler 1073 form at least part of a second signal path. Accordingly, the first amplifier 1072a is arranged in the first signal path, and the second amplifier 1072b in the second signal path.

The first coupler 1071 is configured to divide an input signal received from the first port 108 or the fourth port 111, into a first part and a second part. In particular, the input signal is the transmit input signal 112 or the cancellation input signal 106. For either of the signal 112 or 106, a phase difference of 90° is thereby generated between the first part and the second part. The first amplifier 1072a is configured to amplify the first part, and the second amplifier 1072b is configured to amplify the second part. The second coupler 1073 is further configured to combine the amplified first and second parts of the input signal to form a first and second output signal at the second port 109 and third port 110, respectively. Thereby, the amplified first and second transmit input signal parts are combined such that they constructively form the transmit signal 102 at the second port 109 and destructively cancel each other at the third port 110. In this way, the transmit signal 102 is generated from the transmit input signal 112 and is output only at the second port 109 to the antenna 200.

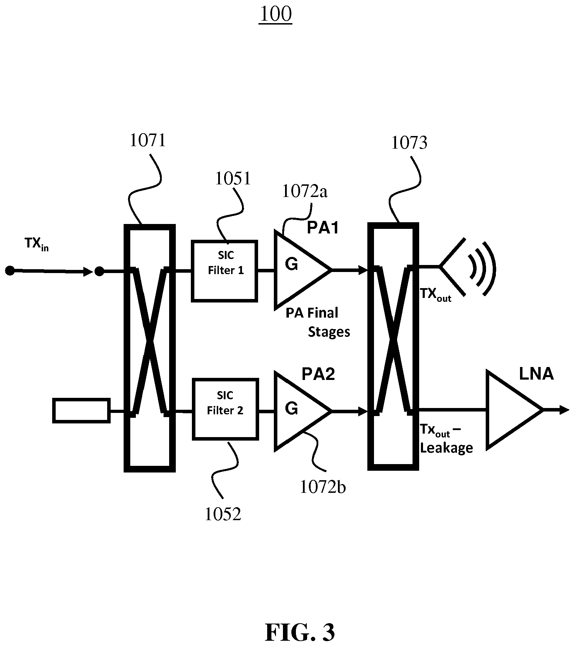

FIG. 3 shows a multi-mode RF front end 100 according to an embodiment of the invention, which builds on the RF front end 100 shown in FIG. 1 and/or FIG. 2. The cancellation input signal generator 105 may comprise a first SIC filter 1051 arranged between the first coupler 1071 and the first amplifier 1072a, and a second SIC filter 1052 arranged between the first coupler 1071 and the second amplifier 1072b.

In particular, the first SIC filter 1051 is configured to receive the first part of the input signal from the first coupler 1071. The first SIC filter 1051 is further configured to generate a first cancellation input signal, and to output the first cancellation input signal to the first amplifier 1072a. Similarly, the second SIC filter 1052 is configured to receive the second part of the input signal from the first coupler 1071. And the second SIC filter 1052 is further configured to generate a second cancellation input signal, and to output the second cancellation input signal to the second amplifier 1072b.

In this way, the first cancellation input signal and the second cancellation input signal are fed to the first amplifier 1072a and the second amplifier 1072b, respectively. Then the amplified first and second cancellation input signals are combined in the second coupler 1073. Particularly the second coupler 1073 is further configured to combine the amplified first and second cancellation input signals such that they constructively form the cancellation signal 113 at the third port 110 and destructively cancel each other at the second port 109. Further, also in this way, the cancellation signal 113 is generated from the first and second cancellation input signals and is output only at the third port 110 to the signal processing section 300 (here including a LNA 201). It should be noted here that 1051 and 1052 both generate different signals that for both include TX and Cancellation signals. As in all other cases, each amplifier than amplifies a different "mixed" version of both TX and SIC signals. As can be seen in Fig.2, the input to PA1 and PA2 includes the two mentioned TX and SIC signals but in a different phase combination that enable a TX summation by 1073 at 109 (subtracts at 110) while SIC is summed simultaneously by 1073 at 110 (and sure subtracts at 109). This is true for all embodiments here.

A maximum SIC degree of freedom may be achieved by implementing two independent SIC filters (e.g. analog SIC filters) at each PA input. This however may not provide the smallest form factor or efficiency especially with passive delay lines SIC. It may also generate noise and non-linearity with active SIC filters.

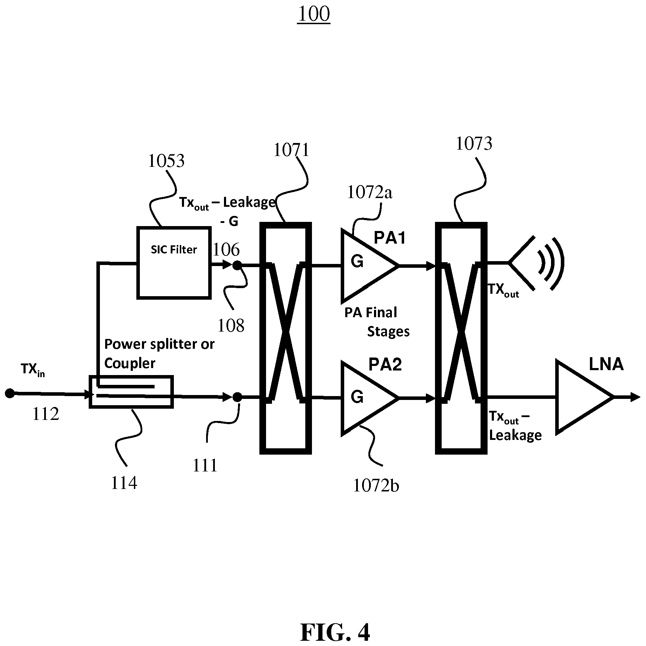

FIG. 4 shows a multi-mode RF front end 100 according to another embodiment of the invention, which also builds on the RF front end 100 shown in FIG. 1 and/or FIG. 2. Optionally, the RF front end 100 further comprises a splitter 114, and the cancellation input signal generator 105 comprises a third SIC filter 1053. The splitter 114 is configured to receive and split the transmit input signal 112 into a third and fourth parts. The splitter 114 is further configured to output the third part of the transmit input signal 112 to the third SIC filter 1053. The splitter 114 is further configured to output the fourth part of the transmit input signal 112 to the fourth port 111 of the QBPA 107 connected to the first coupler 1071.

The fourth part of the transmit input signal 112 is fed into the QBPA 107. Accordingly, the transmit signal 102 will be constructed based on the fourth part of the transmit input signal 112.

The third SIC filter 1053 is configured to receive the third part of the transmit input signal 112 from the splitter 114. The third SIC filter 1053 is further configured to generate and output the cancellation input signal 106 to the first port 108 of the QBPA 107 connected to the first coupler 1071. In this way, the cancellation input signal 106 is also fed into the QBPA 107. Accordingly, the cancellation signal 113 will be constructed based on the cancellation input signal 106.

It should be noted that, alternatively a TX signal can be split into two different QBPA inputs. The TX signal is higher in power and the SIC signal will be fed to the other input after passing an analog SIC filter. This alternative may better suit a passive SIC filtering design.

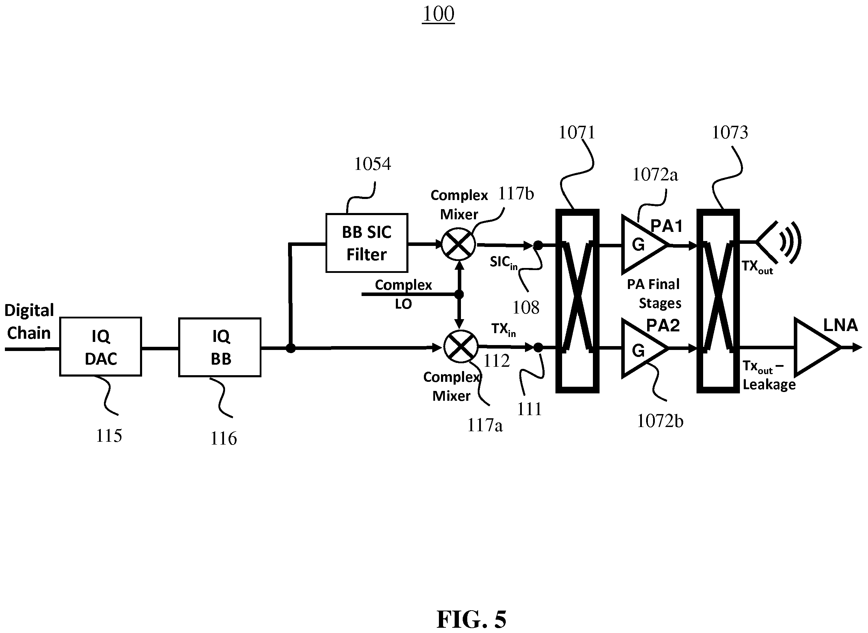

FIG. 5 shows a multi-mode RF front end 100 according to another embodiment of the invention, which also builds on the RF front end 100 shown in FIG. 1 and/or FIG. 2. Optionally, the RF front end 100 further comprises an IQ DAC 115, an IQ BB 116, and a first mixer 117a and a second mixer 117b. The cancellation input signal generator 105 comprises a BB SIC filter 1054. The IQ DAC 115 is configured to receive and convert a digital signal to an analog signal, and output the analog signal to the IQ BB. Accordingly, the IQ BB 116 is configured to receive the analog signal from the IQ DAC 115. The IQ BB 116 is further configured to generate a BB signal from the analog signal and output the BB signal to the BB SIC filter 1054 and the first mixer 117a. The BB SIC filter 1054 is configured to receive the BB signal from the IQ BB 116, generate a BB cancellation input signal from the BB signal and output the BB cancellation input signal to the second mixer 117b.

Additionally, a complex low-frequency signal is provided in this embodiment. The first mixer 117a is configured to receive the BB signal from the IQ BB 116. The first mixer 117a is further configured to mix the BB signal with the low-frequency signal to form the transmit input signal 112, and output the transmit input signal 112 to the fourth port 111 of the QBPA 107. The second mixer 117b is configured to receive the BB cancellation input signal from the BB SIC filter 1054. The second mixer 117b is also configured to mix the BB cancellation signal with the low-frequency signal to form the cancellation input signal 106, and output the cancellation input signal 106 to the first port 108 of the QBPA 107.

Accordingly, the transmit signal 102 and the cancellation signal 113 will be constructed, respectively, based on the transmit input signal 112 and the cancellation input signal 106 fed into the QBPA 107, respectively.

Notably, the implementation of RF SIC filters may be too large physically and/or too complicated in some applications. In this way, a simple analog baseband SIC implementation may be up-converted to RF as described here.

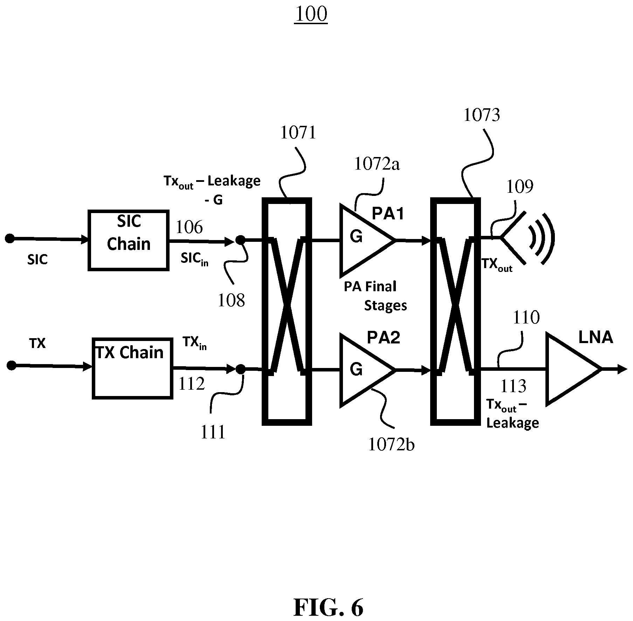

FIG. 6 shows a multi-mode RF front end 100 according to another embodiment of the invention, which also builds on the RF front end 100 shown in FIG. 1 and/or FIG. 2. In particular, a SIC chain and a TX chain may be implemented separately.

The QBPA 107 is configured to receive the cancellation input signal 106 from the cancellation input signal generator 105 at the first port 108. And the QBPA 107 is also configured to receive the transmit input signal 112 at the fourth port 111.

The implementation of analog SIC filters may be too large physically and/or too complicated in some applications. Thus a simple digital BB SIC implementation maybe designed to upconvert digital signals to RF signals.

Optionally, according to the previous embodiments, the cancellation input signal 106 is fed into the QBPA 107. In such scenarios, the cancellation input signal 106 will go through the first coupler 1071 and is divided into the first and second parts of the cancellation input signal. The first and second amplifiers 1072a and 1072b will further amplify the first and second parts of the cancellation input signal, respectively. Accordingly, the second coupler 1073 is further configured to combine the amplified first and second parts of the cancellation input signal such that they constructively form the cancellation signal 113 at the third port 110 and destructively cancel each other at the second port 109. Further, also in this way, the cancellation signal 113 is generated from the first and second parts of the cancellation input signal and is output only at the third port 110 to the signal processing section.

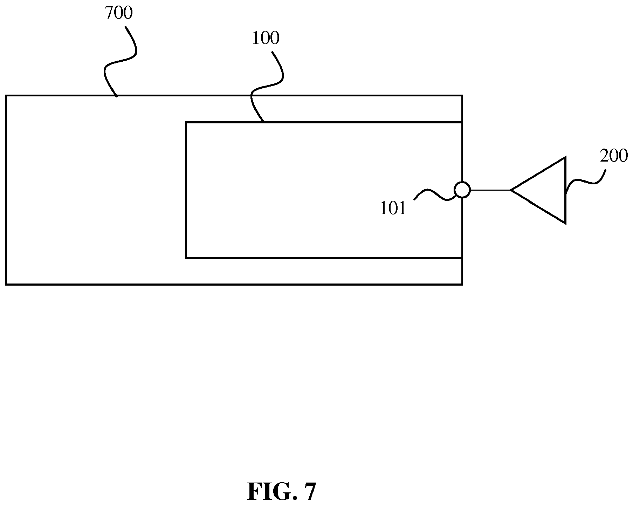

FIG. 7 shows a transceiver 700 (HD, FD or FDD) according to an embodiment of the invention, which transceiver 700 comprises a RF front end 100 according to an embodiment of the present invention, in particular one of the RF front end 100 of FIG. 1 to FIG. 6. The transceiver 700 further comprises a transmit and receive antenna 200 connected to the antenna port 101 of the RF front end 100. The transceiver 700 may be able to operate in HD, FD and/or FDD mode, since the RF front end 100 is a multi-mode RF front end, and can specifically transmit and receive signals via the antenna 200 simultaneously. Due to the use of the RF front end 100, a transmit signal leakage is thereby greatly reduced in the transceiver 700.

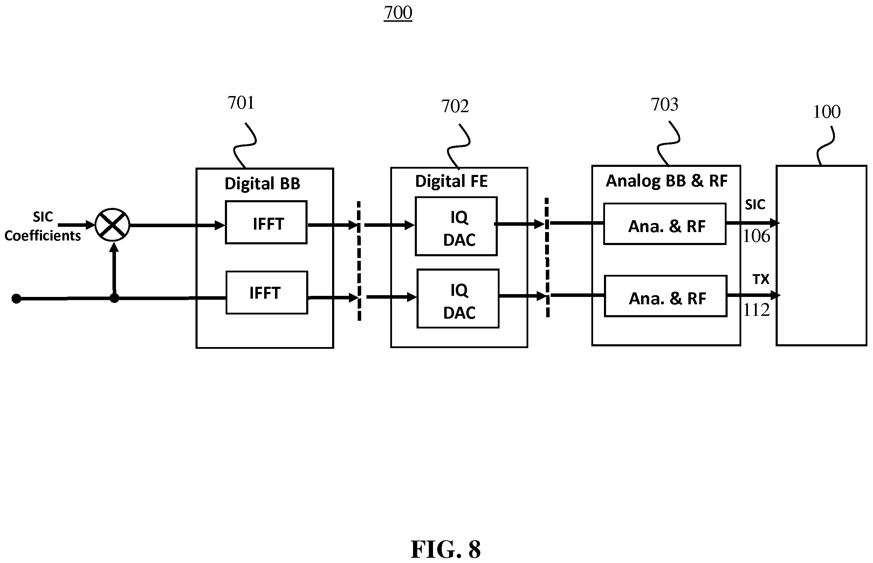

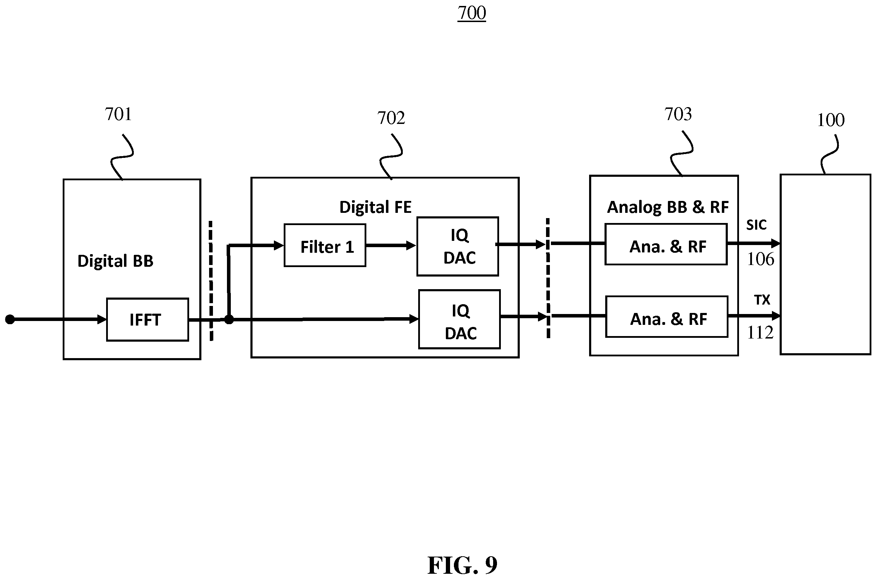

FIG. 8 and FIG. 9 both show digital Full TX Chain Implementations for separate TX/SIC implementation. Particularly the RF front end 100 is the RF front end 100 of FIG. 6.

The transceiver 700 further comprises a digital baseband processing module 701, a digital front end 702 and an analog baseband and RF processing module 703. The digital baseband processing module 701 is configured to receive a frequency-domain signal, and generate a first and second time-domain sequences from the frequency-domain signal. In particular, the digital baseband processing module 701 may perform an inverse Fast Fourier Transform (IFFT) on the frequency-domain signal.

The digital baseband processing module 701 is further configured to output the first and second sequences to the digital front end 702. The digital front end 702 is configured to receive the first and second sequences from the digital baseband processing module 701. The digital front end 702 is also configured to convert the received first and second sequences, and output converted first and second sequences to the analog baseband and RF processing module 703. Optionally, the digital front end 702 may comprise IQ DACs.

Accordingly, the analog baseband and RF processing module 703 is configured to receive the converted first and second sequences from the digital front end 702. The analog baseband and RF processing module 703 is configured to generate a cancellation input signal 106 from the converted first sequence, and output the cancellation input signal 106 to a first port 108 of a QBPA 107 in the RF front end 100. Then the analog baseband and RF processing module 703 is further configured to generate a transmit input signal 112 from the converted second sequence and output the transmit input signal 112 to a fourth port 111 of the QBPA 107 in the RF front end 100. In this way, a transmit input signal 112 and a cancellation input signal 106 are constructed from digital signals, respectively. In a next stage, the transmit input signal 112 and the cancellation input signal 106 are fed into the RF front end 100 and processed accordingly as discussed in the previous embodiments.

As shown in FIG. 8, the digital baseband processing module 701 is further configured to convert a mix of the frequency-domain signal and SIC coefficients to form the first sequence. Particularly, the IFFT is performed on the frequency-domain signal to generate the second sequence. Meanwhile, the IFFT is performed on the mix of the frequency signal and the SIC coefficient, to generate the first sequence. Accordingly, the first sequence is used to form an SIC signal, and the second sequence is used to form a TX signal.

In another digital implementation as shown in FIG. 9, optionally the first sequence may be identical to the second sequence. In other words, the time-domain signal after IFFT processing is fed into the digital front end 702. The digital front end 702 is further configured to filter the received time-domain signal after IFFT processing before converting it. In this manner, only a single IFFT is used, and the application of the SIC coefficients is replaced with a filter applied on the time-domain signal.

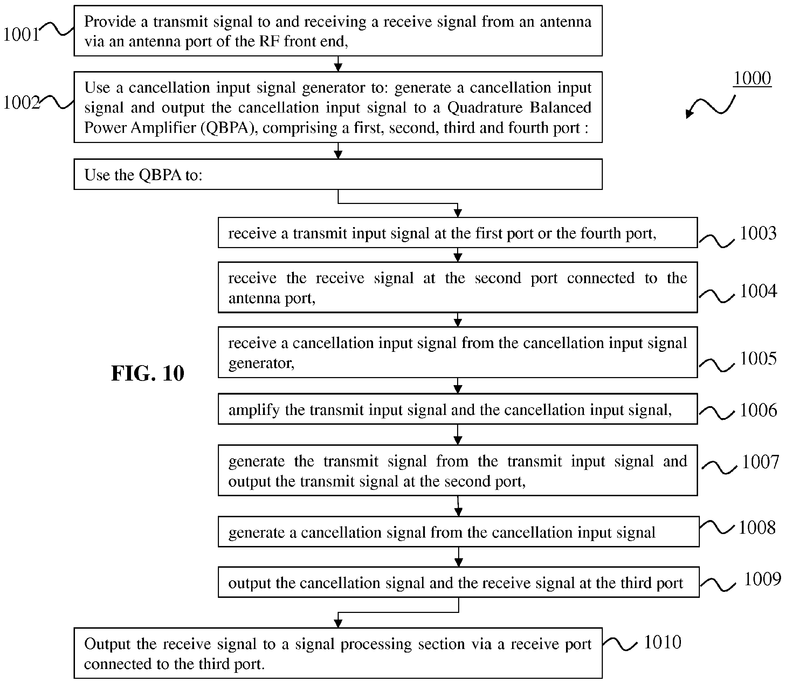

FIG. 10 shows a method 1000 according to an embodiment not falling within the scope of the claimed subject-matter. The method 1000 is for performing a wireless communication using a RF front end 100, in particular the RF front end 100 shown in one of FIG. 1 to FIG. 6. The method 1000 comprises a step 1001 of providing a transmit signal 102 to and receiving a receive signal 103 from an antenna 200 via an antenna port 101 of the RF front end 100. Further, the method 1000 comprises a step 1002 of using a cancellation input signal generator to generate a cancellation input signal and output the cancellation input signal to a QBPA 107 comprising a first, second, third and fourth port. The method 1000 further comprises using the QBPA 107 to: perform a step 1003 of receiving a transmit input signal 112 at a first port 108 or a fourth port 111, perform a step 1004 of receiving the receive signal 103 at the second port 109 connected to the antenna port 101, perform a step 1005 of receiving a cancellation input signal 106 from the cancellation input signal generator 105, perform a step 1006 of amplifying the transmit input signal 112 and the cancellation input signal 106, perform a step 1007 of generating the transmit signal 102 from the transmit input signal 112 and output the transmit signal 102 at the second port 109, perform a step 1008 of generating a cancellation signal 113 from the cancellation input signal 106, perform a step 1009 of outputting the cancellation signal 113 and the receive signal 103 at a third port 110. Finally, the method 1000 comprises a step 1010 of outputting the receive signal 103 to a signal processing section 201 via a receive port 104 connected to the third port 110.

In summary, embodiments of the present invention achieve multiple benefits. Advantages are:
- The RF front end can be integrated on chip especially the digital to RF configurations.
- Wide-band cancellation of antenna reflections are possible.
- A very power efficient SIC implementation is achieved.
- Low SIC Signal to Noise degradation is achieved.

In the claims as well as in the description the word "comprising" does not exclude other elements or steps and the indefinite article "a" or "an" does not exclude a plurality. A single element or other unit may fulfill the functions of several entities or items recited in the claims.

## Claims

1. Radio Frequency, RF, front end (100) for wireless communication, comprising
an antenna port (101) for outputting a transmit signal (102) to and receiving a receive signal (103) from an antenna (200),
a receive port (104) for outputting the receive signal (103) to a signal processing section (300),
a cancellation input signal generator (105) for generating a cancellation input signal (106) and outputting the cancellation input signal (106) to a Quadrature Balanced Power Amplifier (107), QBPA, and
the QBPA (107) comprising a first, second, third and fourth port (108, 109, 110, 111), wherein the QBPA (107) is configured to:
- receive a transmit input signal (112) at the first port (108) or the fourth port (111),
- receive the receive signal (103) at the second port (109) connected to the antenna port (101),
- receive the cancellation input signal (106) from the cancellation input signal generator (105),
- amplify the transmit input signal (112) and the cancellation input signal (106),
- generate the transmit signal (102) from the transmit input signal (112) and output the transmit signal (102) at the second port (109),
- generate a cancellation signal (113) from the cancellation input signal (106) and output the cancellation signal (113) and the receive signal (103) at the third port (110) connected to the receive port (104).

2. RF front end (100) according to claim 1, wherein
the cancellation input signal generator (105) is configured to generate the cancellation input signal (106) based on the transmit input signal (112) and/or based on an SIC signal received at the first or fourth port (108, 111).

3. RF front end (100) according to claim 1 or 2, wherein
the cancellation input signal generator (105) is configured to generate the cancellation input signal (106) in a manner that the cancellation signal (113) cancels a leakage signal caused at the third port (110) when the transmit signal (102) is output from the second port (109).

4. RF front end (100) according to one of the claims 1 to 3, wherein
the QBPA (107) comprises:
a first coupler (1071) configured to divide an input signal received from the first or the fourth port (108, 111) of the QBPA (107) into a first part and second part, with a phase difference of 90° between the first part and second part, wherein the input signal is the transmit input signal (112) or the cancellation input signal (106);
a first amplifier (1072a) configured to amplify the first part of the input signal and output the amplified first part of the input signal to a second coupler (1073);
a second amplifier (1072b) configured to amplify the second part of the input signal and output the amplified second part of the input signal to the second coupler (1073); and
the second coupler (1073) configured to combine the amplified first and second parts of the input signal to form a first and second output signal at the second and third ports (109, 110) of the QBPA (107), respectively.

5. RF front end (100) according to claim 4, wherein the input signal of the first coupler (1071) comprises the transmit input signal (112), wherein
the second coupler (1073) is configured to combine the amplified first and second parts of the transmit input signal (112) such that they constructively form the transmit signal (102) at the second port (109) and destructively cancel each other at the third port (110).

6. RF front end (100) according to claim 4 or 5, wherein
the cancellation input signal generator (105) comprises a first SIC filter (1051) arranged between the first coupler (1071) and the first amplifier (1072a), and a second SIC filter (1052) arranged between the first coupler (1071) and the second amplifier (1072b),
wherein the first SIC filter (1051) is configured to:
receive the first part of the input signal from the first coupler (1071),
generate a first cancellation input signal, and
output the first cancellation input signal to the first amplifier (1072a);
and the second SIC filter (1052) is configured to:
receive the second part of the input signal from the first coupler (1071),
generate a second cancellation input signal, and
output the second cancellation input signal to the second amplifier (1072b).

7. RF front end (100) according to claim 6, wherein
the second coupler (1073) is further configured to combine the amplified first and second cancellation input signals such that they constructively form the cancellation signal (113) at the third port (110) and destructively cancel each other at the second port (109).

8. RF front end (100) according to claim 4 or 5, wherein
the RF front end (100) further comprises a splitter (114), and the cancellation input signal generator (105) comprises a third SIC filter (1053),
wherein the splitter (114) is configured to
receive the transmit input signal (112),
split the transmit input signal (112) into a third and fourth parts,
output the third part of the transmit input signal (112) to the third SIC filter (1053) and output the fourth part of the transmit input signal (112) to the fourth port (111) of the QBPA (107) connected to the first coupler (1071); and
the third SIC filter (1053) is configured to:
receive the third part of the transmit input signal (112) from the splitter (114),
generate the cancellation input signal (106), and
output the cancellation input signal (106) to the first port (108) of the QBPA (107) connected to the first coupler (1071).

9. RF front end (100) according to claim 4 or 5, wherein
the RF front end (100) further comprises an in-phase and quadrature digital-to-analog converter (115), IQ DAC, an IQ baseband processing component (116), IQ BB, and a first and second mixers (117a, 117b), and
the cancellation input signal generator (105) comprises a BB SIC filter (1054),
wherein the IQ DAC (115) is configured to receive a digital signal, convert the digital signal to an analog signal and output the analog signal to the IQ BB (116);
the IQ BB (116) is configured to receive the analog signal from the IQ DAC (115), generate a BB signal from the analog signal and output the BB signal to the BB SIC filter (1054) and the first mixer (117a);
the BB SIC filter (1054) is configured to receive the BB signal from the IQ BB (116), generate a BB cancellation input signal from the BB signal and output the BB cancellation input signal to the second mixer (117b);
the first mixer (117a) is configured to receive the BB signal from the IQ BB (116), mix the BB signal with a low-frequency signal to form the transmit input signal (112), and output the transmit input signal (112) to the fourth port (111) of the QBPA (107);
the second mixer (117b) is configured to receive the BB cancellation input signal from the BB SIC filter (1054), mix the BB cancellation signal with the low-frequency signal to form the cancellation input signal (106), and output the cancellation input signal (106) to the first port (108) of the QBPA (107).

10. RF front end (100) according to one of the claim 1 to 5, wherein
the QBPA (107) is configured to:
receive the cancellation input signal (106) from the cancellation input signal generator (105) at the first port (108), and
receive the transmit input signal (112) at the fourth port (111).

11. RF front end (100) according to one of the claims 8 to 10, wherein
the second coupler (1073) is further configured to combine the amplified first and second parts of the cancellation input signal (106) such that they constructively form the cancellation signal (113) at the third port (110) and destructively cancel each other at the second port (109).

12. Full Duplex or Half Duplex (700) transceiver comprising
a Radio Frequency, RF, front end (100) according to one of the claims 1 to 11, and
a transmit and receive antenna (200) connected to the antenna port (101) of the RF front end (100).

13. Full Duplex or Half Duplex transceiver (1000) according to claim 12, wherein the RF front end (100) is the RF front end (100) according to claim 10,
the transceiver (700) further comprises a digital baseband processing module (701), a digital front end (702) and an analog baseband and RF processing module (703),
wherein the digital baseband processing module (701) is configured to:
- receive a frequency signal,
- generate a first and second sequences from the frequency signal, and
- output the first and second sequences to the digital front end (702);
the digital front end (702) is configured to:
- receive the first and second sequences from the digital baseband processing module (701),
- convert the received first and second sequences, and
- output converted first and second sequences to the analog baseband and RF processing module (703); and
the analog baseband and RF processing module (703) is configured to:
- receive the converted first and second sequences from the digital front end (702),
- generate a cancellation input signal (106) from the converted first sequence and output the cancellation input signal (106) to a first port (108) of a QBPA (107) in the RF front end (100), and
- generate a transmit input signal (112) from the converted second sequence and output the transmit input signal (112) to a fourth port (111) of the QBPA (107) in the RF front end (100).

14. Full Duplex or Half Duplex transceiver (700) according to claim 13, wherein
the digital baseband processing module (701) is further configured to convert a mix of the frequency signal and a SIC coefficient to form the first sequence.

15. Full Duplex or Half Duplex transceiver (700) according to claim 13, wherein
the first sequence is identical to the second sequence, and
the digital front end (702) is further configured to filter the received first sequence before converting it.

## Patentansprüche

1. Hochfrequenz-Front-End, HF-Front-End, (100) für eine drahtlose Kommunikation, das umfasst:
einen Antennenanschluss (101) zum Ausgeben eines Sendesignals (102) an eine Antenne (200) und Empfangen eines Empfangssignals (103) von dieser,
einen Empfangsanschluss (104) zum Ausgeben des Empfangssignals (103) an einen Signalverarbeitungsbereich (300),
einen Aufhebungseingangssignalerzeuger (105) zum Erzeugen eines Aufhebungseingangssignals (106) und Ausgeben des Aufhebungseingangssignals (106) an einen symmetrischen Quadraturleistungsverstärker (107), QBPA, und
wobei der QBPA (107) einen ersten, einen zweiten, einen dritten und einen vierten Anschluss (108, 109, 110, 111) umfasst, wobei der QBPA (107) konfiguriert ist zum:
- Empfangen eines Sendeeingangssignals (112) an dem ersten Anschluss (108) oder dem vierten Anschluss (111),
- Empfangen des Empfangssignals (103) an dem zweiten Anschluss (109), der mit dem Antennenanschluss (101) verbunden ist,
- Empfangen des Aufhebungseingangssignals (106) von dem
Aufhebungseingangssignalerzeuger (105),
- Verstärken des Sendeeingangssignals (112) und des Aufhebungseingangssignals (106),
- Erzeugen des Sendesignals (102) aus dem Sendeeingangssignal (112) und Ausgeben des Sendesignals (102) an dem zweiten Anschluss (109),
- Erzeugen eines Aufhebungssignals (113) aus dem Aufhebungseingangssignal (106) und Ausgeben des Aufhebungssignals (113) und des Empfangssignals (103) an dem dritten Anschluss (110), der mit dem Empfangsanschluss (104) verbunden ist.

2. HF-Front-End (100) nach Anspruch 1, wobei
der Aufhebungseingangssignalerzeuger (105) konfiguriert ist, um das Aufhebungseingangssignal (106) basierend auf dem Sendeeingangssignal (112) und/oder basierend auf einem SIC-Signal, das an dem ersten oder dem vierten Anschluss (108, 111) empfangen wird, zu erzeugen.

3. HF-Front-End (100) nach Anspruch 1 oder 2, wobei
der Aufhebungseingangssignalerzeuger (105) konfiguriert ist, um das Aufhebungseingangssignal (106) auf eine Weise zu erzeugen, dass das Aufhebungssignal (113) ein Lecksignal, das an dem dritten Anschluss (110) verursacht wird, aufhebt, wenn das Sendesignal (102) von dem zweiten Anschluss (109) ausgegeben wird.

4. HF-Front-End (100) nach einem der Ansprüche 1 bis 3, wobei der QBPA (107) umfasst:
einen ersten Koppler (1071), der konfiguriert ist, um ein Eingangssignal, das von dem ersten oder dem vierten Anschluss (108, 111) des QBPA (107) empfangen wird, in einen ersten Teil und einen zweiten Teil zu unterteilen, mit einer Phasendifferenz von 90° zwischen dem ersten Teil und dem zweiten Teil, wobei das Eingangssignal das Sendeeingangssignal (112) oder das Aufhebungseingangssignal (106) ist;
einen ersten Verstärker (1072a), der konfiguriert ist, um den ersten Teil des Eingangssignals zu verstärken und den verstärkten ersten Teil des Eingangssignals an einen zweiten Koppler (1073) ausgeben;
einen zweiten Verstärker (1072b), der konfiguriert ist, um den zweiten Teil des Eingangssignals zu verstärken und den verstärkten zweiten Teil des Eingangssignals an den zweiten Koppler (1073) auszugeben; und
wobei der zweite Koppler (1073) konfiguriert ist, um den verstärkten ersten und zweiten Teil des Eingangssignals zu kombinieren, um ein erstes und ein zweites Ausgangssignal an dem zweiten beziehungsweise dem dritten Anschluss (109, 110) des QBPA (107) auszubilden.

5. HF-Front-End (100) nach Anspruch 4, wobei das Eingangssignal des ersten Kopplers (1071) das Sendeeingangssignal (112) umfasst, wobei
der zweite Koppler (1073) konfiguriert ist, um den verstärkten ersten und zweiten Teil des Sendeeingangssignals (112) derart zu kombinieren, dass sie das Sendesignal (102) an dem zweiten Anschluss (109) konstruktiv ausbilden und sich an dem dritten Anschluss (110) gegenseitig destruktiv aufheben.

6. HF-Front-End (100) nach Anspruch 4 oder 5, wobei
der Aufhebungseingangssignalerzeuger (105) einen ersten SIC-Filter (1051), der zwischen dem ersten Koppler (1071) und dem ersten Verstärker (1072a) angeordnet ist, und einen zweiten SIC-Filter (1052), der zwischen dem ersten Koppler (1071) und dem zweiten Verstärker (1072b) angeordnet ist, umfasst,
wobei der erste SIC-Filter (1051) konfiguriert ist zum:
Empfangen des ersten Teils des Eingangssignals von dem ersten Koppler (1071),
Erzeugen eines ersten Aufhebungseingangssignals, und
Ausgeben des ersten Aufhebungseingangssignals an den ersten Verstärker (1072a);
wobei der zweite SIC-Filter (1052) konfiguriert ist zum:
Empfangen des zweiten Teils des Eingangssignals von dem ersten Koppler (1071), Erzeugen eines zweiten Aufhebungseingangssignals, und
Ausgeben des zweiten Aufhebungseingangssignals an den zweiten Verstärker (1072b).

7. HF-Front-End (100) nach Anspruch 6, wobei
der zweite Koppler (1073) ferner konfiguriert ist, um das verstärkte erste und zweite Aufhebungseingangssignal derart zu kombinieren, dass sie das Aufhebungssignal (113) an dem dritten Anschluss (110) konstruktiv ausbilden und sich an dem zweiten Anschluss (109) gegenseitig destruktiv aufheben.

8. HF-Front-End (100) nach Anspruch 4 oder 5, wobei
das HF-Front-End (100) ferner einen Splitter (114) umfasst und der Aufhebungseingangssignalerzeuger (105) einen dritten SIC-Filter (1053) umfasst, wobei der Splitter (114) konfiguriert ist zum:
Empfangen des Sendeeingangssignals (112),
Splitten des Sendeeingangssignals (112) in einen dritten und einen vierten Teil,
Ausgeben des dritten Teils des Sendeeingangssignals (112) an den dritten SIC-Filter (1053) und Ausgeben des vierten Teils des Sendeeingangssignals (112) an den vierten Anschluss (111) des QBPA (107), der mit dem ersten Koppler (1071) verbunden ist; und
wobei der dritte SIC-Filter (1053) konfiguriert ist zum:
Empfangen des dritten Teils des Sendeeingangssignals (112) von dem Splitter (114), Erzeugen des Aufhebungseingangssignals (106), und
Ausgeben des Aufhebungseingangssignals (106) an den ersten Anschluss (108) des QBPA (107), der mit dem ersten Koppler (1071) verbunden ist.

9. HF-Front-End (100) nach Anspruch 4 oder 5, wobei
das HF-Front-End (100) ferner einen phasengleichen und Quadratur-Digital-AnalogWandler (115), IQ DAC, eine IQ-Basisbandverarbeitungskomponente (116), IQ BB, und einen ersten und einen zweiten Mischer (117a, 117b) umfasst, und
der Aufhebungseingangssignalerzeuger (105) einen BB-SIC-Filter (1054) umfasst, wobei der IQ DAC (115) konfiguriert ist, um ein digitales Signal zu empfangen, das digitale Signal in ein analoges Signal umzuwandeln und das analoge Signal an die IQ BB (116) auszugeben;
die IQ-BB (116) konfiguriert ist, um das analoge Signal von dem IQ-DAC (115) zu empfangen, ein BB-Signal aus dem analogen Signal zu erzeugen und das BB-Signal an den BB-SIC-Filter (1054) und den ersten Mischer (117a) auszugeben;
der BB-SIC-Filter (1054) konfiguriert ist, um das BB-Signal von der IQ-BB (116) zu empfangen, ein BB-Aufhebungseingangssignal aus dem BB-Signal zu erzeugen und das BB-Aufhebungseingangssignal an den zweiten Mischer (117b) auszugeben;
der erste Mischer (117a) konfiguriert ist, um das BB-Signal von der IQ-BB (116) zu empfangen, das BB-Signal mit einem Niederfrequenzsignal zu mischen, um das Sendeeingangssignal (112) auszubilden und das Sendeeingangssignal (112) an den vierten Anschluss (111) des QBPA (107) auszugeben;
der zweite Mischer (117b) konfiguriert ist, um das BB-Aufhebungseingangssignal von dem BB-SIC-Filter (1054) zu empfangen, das BB-Aufhebungssignal mit dem Niederfrequenzsignal zu mischen, um das Aufhebungseingangssignal (106) auszubilden, und das Aufhebungseingangssignal (106) an den ersten Anschluss (108) des QBPA (107) auszugeben.

10. HF-Front-End (100) nach einem der Ansprüche 1 bis 5, wobei der QBPA (107) konfiguriert ist zum:
Empfangen des Aufhebungseingangssignals (106) von dem Aufhebungseingangssignalerzeuger (105) an dem ersten Anschluss (108), und
Empfangen des Sendeeingangssignals (112) an dem vierten Anschluss (111).

11. HF-Front-End (100) nach einem der Ansprüche 8 bis 10, wobei der zweite Koppler (1073) ferner konfiguriert ist, um den verstärkten ersten und zweiten Teil des Aufhebungseingangssignals (106) derart zu kombinieren, dass sie das Aufhebungssignal (113) an dem dritten Anschluss (110) konstruktiv ausbilden und sich an dem zweiten Anschluss (109) gegenseitig destruktiv aufheben.

12. Vollduplex- oder Halbduplex(700)-Transceiver, der umfasst:
ein Hochfrequenz-Front-End, HF-Front-End, (100) nach einem der Ansprüche 1 bis 11, und
eine Sende- und Empfangsantenne (200), die mit dem Antennenanschluss (101) des HF-Front-End (100) verbunden ist.

13. Vollduplex- oder Halbduplex-Transceiver (1000) nach Anspruch 12, wobei das HF-Front-End (100) das HF-Front-End (100) nach Anspruch 10 ist,
der Transceiver (700) ferner ein digitales Basisbandverarbeitungsmodul (701), ein digitales Front-End (702) und ein analoges Basisband- und HF-Verarbeitungsmodul (703) umfasst,
wobei das digitale Basisbandverarbeitungsmodul (701) konfiguriert ist zum:
- Empfangen eines Frequenzsignals,
- Erzeugen einer ersten und einer zweiten Sequenz aus dem Frequenzsignal, und
- Ausgeben der ersten und der zweiten Sequenz an das digitale Front-End (702);
das digitale Front-End (702) konfiguriert ist zum:
- Empfangen der ersten und der zweiten Sequenz von dem digitalen Basisbandverarbeitungsmodul (701),
- Umwandeln der empfangenen ersten und zweiten Sequenz, und
- Ausgeben der umgewandelten ersten und zweiten Sequenz an das analoge Basisband- und HF-Verarbeitungsmodul (703); und
das analoge Basisband- und HF-Verarbeitungsmodul (703) konfiguriert ist zum:
- Empfangen der umgewandelten ersten und zweiten Sequenz von dem digitalen Front-End (702),
- Erzeugen eines Aufhebungseingangssignals (106) aus der umgewandelten ersten Sequenz und Ausgeben des Aufhebungseingangssignals (106) an einen ersten Anschluss (108) eines QBPA (107) in dem HF-Front-End (100), und
- Erzeugen eines Sendeeingangssignals (112) aus der umgewandelten zweiten Sequenz und Ausgeben des Sendeeingangssignals (112) an einen vierten Anschluss (111) des QBPA (107) in dem HF-Front-End (100).

14. Vollduplex- oder Halbduplex-Transceiver (700) nach Anspruch 13, wobei
das digitale Basisbandverarbeitungsmodul (701) ferner konfiguriert ist, um eine Mischung des Frequenzsignals und eines SIC-Koeffizienten umzuwandeln, um die erste Sequenz auszubilden.

15. Vollduplex- oder Halbduplex-Transceiver (700) nach Anspruch 13, wobei
die erste Sequenz mit der zweiten Sequenz identisch ist, und
das digitale Front-End (702) ferner konfiguriert ist, um die empfangene erste Sequenz vor dem Umwandeln zu filtern.

## Revendications

1. Frontal radiofréquence, RF, (100) destiné à une communication sans fil, comprenant un port d'antenne (101) destiné à délivrer un signal d'émission (102) à une antenne (200) et à recevoir un signal de réception (103) de celle-ci,
un port de réception (104) destiné à délivrer le signal de réception (103) à une section de traitement de signal (300),
un générateur de signal d'entrée d'annulation (105) destiné à générer un signal d'entrée d'annulation (106) et à délivrer le signal d'entrée d'annulation (106) à un amplificateur de puissance équilibré en quadrature (107), QBPA, et
le QBPA (107) comprenant un premier, un deuxième, un troisième et un quatrième port (108, 109, 110, 111), dans lequel le QBPA (107) est configuré pour :
- recevoir un signal d'entrée d'émission (112) au niveau du premier port (108) ou du quatrième port (111),
- recevoir le signal de réception (103) au niveau du deuxième port (109) connecté au port d'antenne (101),
- recevoir le signal d'entrée d'annulation (106) du générateur de signal d'entrée d'annulation (105),
- amplifier le signal d'entrée d'émission (112) et le signal d'entrée d'annulation (106),
- générer le signal d'émission (102) à partir du signal d'entrée d'émission (112) et délivrer le signal d'émission (102) au niveau du deuxième port (109),
- générer un signal d'annulation (113) à partir du signal d'entrée d'annulation (106) et délivrer le signal d'annulation (113) et le signal de réception (103) au niveau du troisième port (110) connecté au port de réception (104).

2. Frontal RF (100) selon la revendication 1, dans lequel
le générateur de signal d'entrée d'annulation (105) est configuré pour générer le signal d'entrée d'annulation (106) sur la base du signal d'entrée d'émission (112) et/ou sur la base d'un signal SIC reçu au niveau du premier ou du quatrième port (108, 111).

3. Frontal RF (100) selon la revendication 1 ou 2, dans lequel
le générateur de signal d'entrée d'annulation (105) est configuré pour générer le signal d'entrée d'annulation (106) de façon à ce que le signal d'annulation (113) annule un signal de fuite provoqué au niveau du troisième port (110) lorsque le signal d'émission (102) est délivré à partir du deuxième port (109).

4. Frontal RF (100) selon l'une des revendications 1 à 3, dans lequel
le QBPA (107) comprend :
un premier coupleur (1071) configuré pour diviser un signal d'entrée reçu du premier ou du quatrième port (108, 111) du QBPA (107) en une première partie et une deuxième partie, avec une différence de phase de 90° entre la première partie et la deuxième partie, dans lequel le signal d'entrée est le signal d'entrée d'émission (112) ou le signal d'entrée d'annulation (106) ;
un premier amplificateur (1072a) configuré pour amplifier la première partie du signal d'entrée et délivrer la première partie amplifiée du signal d'entrée à un second coupleur (1073) ;
un second amplificateur (1072b) configuré pour amplifier la deuxième partie du signal d'entrée et délivrer la deuxième partie amplifiée du signal d'entrée au second coupleur (1073) ; et
le second coupleur (1073) configuré pour combiner les première et deuxième parties amplifiées du signal d'entrée pour former un premier et un second signal de sortie au niveau des deuxième et troisième ports (109, 110) du QBPA (107), respectivement.

5. Frontal RF (100) selon la revendication 4, dans lequel le signal d'entrée du premier coupleur (1071) comprend le signal d'entrée d'émission (112), dans lequel le second coupleur (1073) est configuré pour combiner les première et deuxième parties amplifiées du signal d'entrée d'émission (112) de telle sorte qu'elles forment de manière constructive le signal d'émission (102) au niveau du deuxième port (109) et s'annulent de manière destructive au niveau du troisième port (110).

6. Frontal RF (100) selon la revendication 4 ou 5, dans lequel le générateur de signal d'entrée d'annulation (105) comprend un premier filtre SIC (1051) disposé entre le premier coupleur (1071) et le premier amplificateur (1072a), et un deuxième filtre SIC (1052) disposé entre le premier coupleur (1071) et le second amplificateur (1072b),
dans lequel le premier filtre SIC (1051) est configuré pour :
recevoir la première partie du signal d'entrée du premier coupleur (1071),
générer un premier signal d'entrée d'annulation, et
délivrer le premier signal d'entrée d'annulation au premier amplificateur (1072a) ;
et le deuxième filtre SIC (1052) est configuré pour :
recevoir la deuxième partie du signal d'entrée du premier coupleur (1071), générer un second signal d'entrée d'annulation, et
délivrer le second signal d'entrée d'annulation au second amplificateur (1072b).

7. Frontal RF (100) selon la revendication 6, dans lequel
le second coupleur (1073) est en outre configuré pour combiner les premier et deuxième signaux d'entrée d'annulation amplifiés de telle sorte qu'ils forment de manière constructive le signal d'annulation (113) au niveau du troisième port (110) et s'annulent de manière destructive au niveau du deuxième port (109).

8. Frontal RF (100) selon la revendication 4 ou 5, dans lequel le frontal RF (100) comprend en outre un séparateur (114), et le générateur de signal d'entrée d'annulation (105) comprend un troisième filtre SIC (1053),
dans lequel le séparateur (114) est configuré pour :
recevoir le signal d'entrée d'émission (112),
séparer le signal d'entrée de transmission (112) en une troisième et une quatrième partie,
délivrer la troisième partie du signal d'entrée d'émission (112) au troisième filtre SIC (1053) et délivrer la quatrième partie du signal d'entrée d'émission (112) au quatrième port (111) du QBPA (107) connecté au premier coupleur (1071) ; et
le troisième filtre SIC (1053) est configuré pour :
recevoir la troisième partie du signal d'entrée d'émission (112) du séparateur (114), générer le signal d'entrée d'annulation (106), et
délivrer le signal d'entrée d'annulation (106) au premier port (108) du QBPA (107) connecté au premier coupleur (1071).

9. Frontal RF (100) selon la revendication 4 ou 5, dans lequel
le frontal RF (100) comprend en outre un convertisseur numérique-analogique en phase et en quadrature (115), DAC IQ, un composant de traitement de bande de base IQ (116), BB IQ, et un premier et un second mélangeur (117a, 117b), et
le générateur de signal d'entrée d'annulation (105) comprend un filtre SIC BB (1054), dans lequel le DAC IQ (115) est configuré pour recevoir un signal numérique, convertir le signal numérique en un signal analogique et délivrer le signal analogique au BB IQ (116) ;
le BB IQ (116) est configuré pour recevoir le signal analogique du DAC IQ (115), générer un signal BB à partir du signal analogique et délivrer le signal BB au filtre SIC BB (1054) et au premier mélangeur (117a) ;
le filtre SIC BB (1054) est configuré pour recevoir le signal BB du BB IQ (116), générer un signal d'entrée d'annulation BB à partir du signal BB et délivrer le signal d'entrée d'annulation BB au second mélangeur (117b) ;
le premier mélangeur (117a) est configuré pour recevoir le signal BB du BB IQ (116), mélanger le signal BB avec un signal basse fréquence pour former le signal d'entrée d'émission (112), et délivrer le signal d'entrée d'émission (112) au quatrième port (111) du QBPA (107) ;
le second mélangeur (117b) est configuré pour recevoir le signal d'entrée d'annulation BB du filtre SIC BB (1054), mélanger le signal d'annulation BB avec le signal basse fréquence pour former le signal d'entrée d'annulation (106), et délivrer le signal d'entrée d'annulation (106) au premier port (108) du QBPA (107).

10. Frontal RF (100) selon l'une des revendications 1 à 5, dans lequel
le QBPA (107) est configuré pour :
recevoir le signal d'entrée d'annulation (106) du générateur de signal d'entrée d'annulation (105) au niveau du premier port (108), et
recevoir le signal d'entrée d'émission (112) au niveau du quatrième port (111).

11. Frontal RF (100) selon l'une des revendications 8 à 10, dans lequel
le second coupleur (1073) est en outre configuré pour combiner les première et
deuxième parties amplifiées du signal d'entrée d'annulation (106) de telle sorte qu'elles forment de manière constructive le signal d'annulation (113) au niveau du troisième port (110) et s'annulent de manière destructive au niveau du deuxième port (109).

12. Émetteur-récepteur en duplex intégral ou semi-duplex (700) comprenant
un frontal radiofréquence, RF, (100) selon l'une des revendications 1 à 11, et
une antenne d'émission et de réception (200) connectée au port d'antenne (101) du frontal RF (100).

13. Émetteur-récepteur en duplex intégral ou semi-duplex (1000) selon la revendication 12, dans lequel le frontal RF (100) est le frontal RF (100) selon la revendication 10,
l'émetteur-récepteur (700) comprend en outre un module de traitement de bande de base numérique (701), un frontal numérique (702) et un module de traitement de bande de base analogique et RF (703),
dans lequel le module de traitement de bande de base numérique (701) est configuré pour:
- recevoir un signal de fréquence,
- générer une première et une seconde séquence à partir du signal de fréquence, et
- délivrer les première et seconde séquences au frontal numérique (702) ;
le frontal numérique (702) est configuré pour :
- recevoir les première et seconde séquences du module de traitement de bande de base numérique (701),
- convertir les première et seconde séquences reçues, et
- délivrer des première et seconde séquences converties au module de traitement de bande de base analogique et RF (703) ; et
le module de traitement de bande de base analogique et RF (703) est configuré pour :
- recevoir les première et seconde séquences converties du frontal numérique (702),
- générer un signal d'entrée d'annulation (106) à partir de la première séquence convertie et délivrer le signal d'entrée d'annulation (106) à un premier port (108) d'un QBPA (107) dans le frontal RF (100), et
- générer un signal d'entrée d'émission (112) à partir de la seconde séquence convertie et délivrer le signal d'entrée d'émission (112) à un quatrième port (111) du QBPA (107) dans le frontal RF (100).

14. Émetteur-récepteur en duplex intégral ou semi-duplex (700) selon la revendication 13, dans lequel
le module de traitement de bande de base numérique (701) est en outre configuré pour convertir un mélange du signal de fréquence et d'un coefficient SIC pour former la première séquence.

15. Émetteur-récepteur en duplex intégral ou semi-duplex (700) selon la revendication 13, dans lequel
la première séquence est identique à la seconde séquence, et
le frontal numérique (702) est en outre configuré pour filtrer la première séquence reçue avant de la convertir.
